# EUROPÄISCHE PATENTSCHRIFT

(11) **EP 0 889 508 B1**
(45) Veröffentlichungstag und Bekanntmachung des Hinweises auf die Patenterteilung: **08.05.2002**
(21) Anmeldenummer: 98111994.4
(22) Anmeldetag: 29.06.1998
(51) Int. Cl.: H01L 21/3213, H01L 21/3205

(54) **Verfahren zum Trockenätzen einer Elektrodenanordnung**
Process for the dry etching of an electrode structure
Procédé pour l'attaque sèche d'une structure d'électrode

(30) Priorität: 03.07.1997 DE 19728474
(43) Veröffentlichungstag der Anmeldung: 07.01.1999
(73) Patentinhaber: Infineon Technologies AG, 81669 München (DE)
(72) Erfinder: Engelhardt, Manfred, Dr., 83620 Feldkirchen-Westerham (DE); Pamler, Werner, Dr., 80686 München (DE); Weinrich, Volker, Dr., 81549 München (DE); Wendt, Hermann, Dr., 85630 Grasbrunn (DE)
(74) Vertreter: Kindermann, Peter, Dipl.-Ing.

(56) Entgegenhaltungen:
- US-A- 5 057 455
- US-A- 5 122 225
- US-A- 5 208 170
- US-A- 5 515 984
- US-A- 5 585 300
- TABARA S: "WSI2/POLYSILICON GATE ETCHING USING TIN HARD MASK IN CONJUNCTION WITH PHOTORESIST" JAPANESE JOURNAL OF APPLIED PHYSICS, Bd. 36, Nr. 4B, April 1997, Seiten 2508-2513, XP000732364

## Beschreibung

Bei der Entwicklung von hochintegrierten Speicherbausteinen, wie z.B. DRAMs bzw. FRAMs sollte die Zellkapazität bei der fortschreitenden Miniaturisierung beibehalten oder sogar noch verbessert werden. Zur Erreichung dieses Ziels werden immer dünnere dielektrische Schichten und gefaltete Kondensatorelektroden (Trench-Zelle, Stack-Zelle) verwendet. In letzter Zeit werden anstatt des herkömmlichen Siliziumoxids neue Materialien, insbesondere Paraelektrika und Ferroelektrika, zwischen den Kondensatorelektroden einer Speicherzelle verwendet. Beispielsweise kommen Bariumstrontiumtitanat (BST, (Ba,Sr)TiO₃), Bleizirkontitanat (PZT, Pb(Zr,Ti)O₃) bzw. Lanthan-dotiertes Bleizirkontitanat oder Strontiumwismuttantalat (SBT, SrBi₂Ta₂O₉) für die Kondensatoren der Speicherzellen bei DRAMs bzw. FRAMs zum Einsatz.

Dabei werden diese Materialien üblicherweise auf bereits vorhandenen Elektroden (Bodenelektroden) abgeschieden. Die Prozessierung erfolgt unter hohen Temperaturen, so daß die Materialien, aus denen normalerweise die Kondensatorelektroden bestehen, so z.B. dotiertes Polysilizium, leicht oxidiert werden und ihre elektrisch leitenden Eigenschaften verlieren, was zum Ausfall der Speicherzelle führen würde.

Wegen ihrer guten Oxidationsbeständigkeit und/oder der Ausbildung elektrisch leitfähiger Oxide gelten 4d und 5d Übergangsmetalle, insbesondere Platinmetalle (Ru, Rh, Pd, Os, Ir, Pt) und insbesondere Platin selbst, sowie Rhenium als aussichtsreiche Kandidaten, die dotiertes Polysilizium als Elektrodenmaterial in den obengenannten Speicherzellen ersetzen könnten (US 5,585,300).

Um aus den genannten, bisher in der Halbleitertechnologie noch nicht verbreiteten Materialien eine Speicherzelle aufbauen zu können, müssen dünne Schichten dieser Materialien strukturiert werden.

Die Strukturierung der bisher verwendeten Materialien erfolgt in der Regel durch sogenannte plasmaunterstützte anisotrope Ätzverfahren. Dabei werden üblicherweise physikalischchemische Verfahren angewandt, bei denen Gasgemische aus einem oder mehreren reaktiven Gasen, wie z.B. Sauerstoff, Chlor, Brom, Chlorwasserstoff, Bromwasserstoff bzw. halogenierten Kohlenwasserstoffen und aus Edelgasen (z.B. Ar, He) verwendet werden. Diese Gasgemische werden in der Regel in einem elektromagnetischen Wechselfeld bei geringen Drücken angeregt (US 5,515,984).

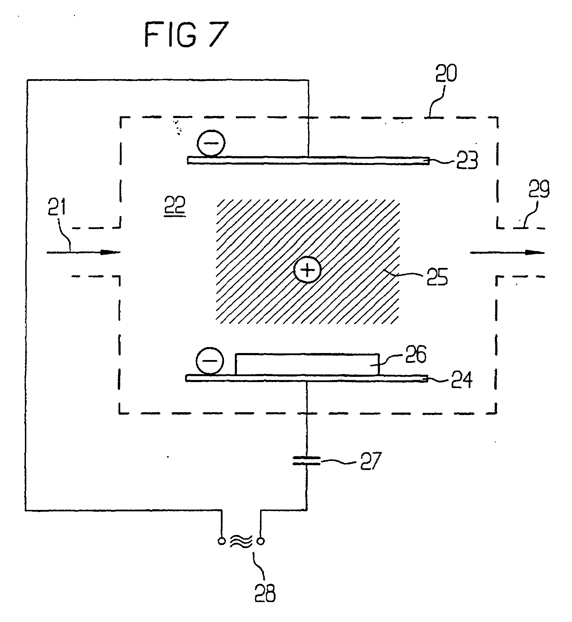

Fig. 7 zeigt die prinzipielle Arbeitsweise einer Ätzkammer, dargestellt am Beispiel eines Parallelplattenreaktors 20. Das Gasgemisch, z.B. Ar und Cl₂, wird über den Gaseinlass 21 der eigentlichen Reaktorkammer 22 zugeführt und durch den Gasauslass 29 wieder abgepumpt. Die untere Platte 24 des Parallelplattenreaktors ist über eine Kapazität 27 mit einer Hochfrequenzquelle 28 verbunden und dient als Substrathalter. Durch das Anlegen eines hochfrequenten elektrischen Wechselfeldes an die obere und die untere Platte 23, 24 des Parallelplattenreaktors wird das Gasgemisch in ein Plasma 25 überführt. Da die Beweglichkeit der Elektronen größer als die der Gaskationen ist, laden sich die obere und die untere Platte 23, 24 gegenüber dem Plasma 25 negativ auf. Daher üben beide Platten 23, 24 auf die positiv geladenen Gaskationen eine hohe Anziehungskraft aus, so daß sie einem permanenten Bombardement durch diese Ionen, z.B. Ar⁺ ausgesetzt sind. Da der Gasdruck zudem niedrig gehalten wird, typischerweise 0.1 - 10 Pa, findet nur eine geringfügige Streuung der Ionen untereinander und an den Neutralteilchen statt, und die Ionen treffen nahezu senkrecht auf die Oberfläche eines Substrats 26, das auf der unteren Platte 24 des Parallelplattenreaktors gehalten ist. Dies erlaubt eine gute Abbildung einer Maske (nicht gezeigt) auf die darunterliegende, zu ätzende Schicht des Substrats 26.

Üblicherweise werden als Maskenmaterialien Photolacke verwendet, da diese durch einen Belichtungsschritt und einen Entwicklungsschritt relativ einfach strukturiert werden können.

Der physikalische Teil der Ätzung wird durch Impuls und kinetische Energie der auftreffenden Ionen (z.B. Cl₂⁺, Ar⁺) bewirkt. Zusätzlich werden dadurch chemische Reaktionen zwischen dem Substrat und den reaktiven Gasteilchen (Ionen, Moleküle, Atome, Radikale) unter Bildung flüchtiger Reaktionsprodukte initiiert oder verstärkt (chemischer Teil der Ätzung). Diese chemischen Reaktionen zwischen den Substratteilchen und den Gasteilchen sind verantwortlich für hohe Selektivitäten des Ätzprozesses.

Leider hat sich herausgestellt, daß die oben genannten, in Speicherzellen neu eingesetzten Materialien zu den trockenchemisch nur schwer oder nicht ätzbaren Materialien gehören, bei denen der Ätzabtrag, auch bei der Verwendung "reaktiver" Gase, überwiegend oder fast ausschließlich auf dem physikalischen Anteil der Ätzung beruht (siehe z. B. US 5,515,984).

Wegen der geringen oder fehlenden chemischen Komponente der Ätzung liegt der Ätzabtrag der zu strukturierenden Schicht in der selben Größenordnung wie der Ätzabtrag der Maske bzw. der Unterlage (Ätzstoppschicht), d.h. die Ätzselektivität zur Ätzmaske bzw. Unterlage ist im allgemeinen klein (zwischen etwa 0,3 und 3,0). Dies hat zur Folge, daß durch die Erosion von Masken mit geneigten Flanken und die unvermeidliche Facettenbildung der Masken nur eine geringe Maßhaltigkeit der Strukturierung gewährleistet werden kann. Zur Verbesserung der Selektioität der Ätzung wird daher in der US 5,350,705 die Verwendung einer nach der Ätzung entfernten Titan-Hartmaske vorgeschlagen.

Die genannten Probleme treten auch bei der Strukturierung der Topelelektrode einer Speicherzelle auf, die nach dem Prinzip "capacitor over bitline" mit einem sogenannten "stacked capacitor" aufgebaut ist.

Darüber hinaus führt die Verwendung eines "stacked capacitors" zu Schwierigkeiten bei der Kontaktierung der Speicherzelle. Zum Anschluß der Speicherzelle an eine Metallisierung sind Kontaktlöcher unterschiedlicher Tiefe in eine über und um den Kondensator angeordnete Isolationschicht zu ätzen. Dabei soll diese Kontakloch-Ätzung in unterschiedlichen Tiefen selektiv zu verschiedenen Materialien stoppen. Zur Vereinfachung des Herstellungsprozesses ist die Verwendung von nur einer Maskenebene anzustreben.

Bei einer Speicherzelle nach dem Prinzip "capacitor over bitline" mit einem "stacked capacitor" muß die Kontakloch-Ätzung zuerst auf dem Material der Topelektrode des Kondensators stoppen (US 5,350,705 und US 5,585,300). Dementsprechend ist das Material der Topelektrode das Material, das der größten Überätzung ausgesetzt ist, während andere Kontaktlöcher zu tiefer liegenden Schichten weitergeätzt werden. Besteht die Topelektrode beispielsweise aus Platin, so kann es neben einem Durchbruch der Topelektrode auch zu einer Redeposition von abgesputterten Platin an den Innenwänden der Maskenöffnung kommen. Dies führt zu sogenannten "Fences", dünnen und leitfähigen Strukturen, die auch nach einem Veraschen der Lackmaske bestehen bleiben und zu Kurzschlüssen führen können (US 5,515,984). Außerdem ist es aufgrund der hohen chemischen Inertheit der neu eingesetzten Materialien schwierig, derartige "Fences" aus den Kontaktlöchern zu entfernen.

Außerdem wird auf den Artikel "WSi2/Polysilicon Gate Etching Using TiN Hard Mask in Conjunction with Photoresist", S. Tabara, Jpn. J. Appl. Phys. Vol 36 (1997) pp. 2508-2513, Part 1, No. 4B, April 1997, die Patentschrift US 5,122,225 sowie die nicht vorveröffentlichte Patentschrift US 5,773,314 hingewiesen.

Es ist daher die Aufgabe der vorliegenden Erfindung, ein Verfahren zur Erzeugung einer Elektrodenanordnung bereitzustellen, das die genannten Nachteile vermeidet oder mindert.

Diese Aufgabe wird durch ein Verfahren gemäß Patentanspruch 1 gelöst. Weitere vorteilhafte Ausführungsformen, Ausgestaltungen und Aspekte der vorliegenden Erfindung ergeben sich aus den Unteransprüchen der Beschreibung und den beiliegenden Zeichnungen.

Dabei soll unter einer chemischen Trockenätzung eine übliche chemische Trockenätzung unter Verwendung von, möglicherweise angeregten, Halogenen, Halogenwasserstoffen oder halogenierten Kohlenwasserstoffen oder unter Verwendung von Sauerstoff bei üblichen Temperaturen und Gasdrücken verstanden werden. Weiterhin soll unter einem Material, das durch eine chemische Trockenätzung praktisch nicht ätzbar ist, ein Material verstanden werden, das bei für das jeweilige Material optimalen Prozeßbedingungen eine Ätzrate von kleiner als 1 nm/min aufweist. Dementsprechend soll unter einer geringen Ätzrate eine Ätzrate größer als 1 nm/min bei für das jeweilige Material optimalen Prozeßbedingungen verstanden werden.

Da das Material der ersten Schicht durch eine chemische Trockenätzung praktisch nicht ätzbar ist, wird die erste Schicht während einer üblichen chemisch-physikalischen Trockenätzung vorwiegend durch den physikalischen Teil der chemisch-physikalischen Trockenätzung abgetragen. Im Gegensatz dazu wird die zweite Schicht während einer üblichen chemisch-physikalischen Trockenätzung auch durch den chemischen Teil der chemisch-physikalischen Trockenätzung abgetragen.

Die Erfindung hat den Vorteil, daß sich die effektive Dicke der Elektrodenanordnung um die Höhe der zweiten Schicht erhöht, so daß ein Durchbrechen während der Überätzung bei einer Kontaktierung der Elektrodenanordnung vermieden wird. Ebenso wird die Bildung von nur schwer entfernbaren Redepositionen aus dem Material der ersten Schicht während der Überätzung verhindert.

Weiterhin reduziert sich durch die zweite Schicht der Elektrodenanordnung - bei etwa gleichbleibender Kapazität - der Schichtwiderstand der Elektrodenanordnung. Dadurch wird das Schalten der sogenannten "common plate" beim sogenannten "pulsed-plateline" Betrieb der Speicherzelle beschleunigt, wodurch sich die Zugriffszeit des gesamten Bausteins verkürzt.

Darüber hinaus ermöglicht die zweite Schicht der Elektrodenanordnung eine Einkapselung des Kondensators der Speicherzelle mit einer Oxidschicht.

Bevorzugt enthält die erste Schicht ein 4d oder 5d Übergangsmetall, deren leitende Nitride oder deren leitende Oxide

Insbesondere enthält die erste Schicht Ruthenium, Rhodium, Palladium, Osmium, Iridium, Platin, Gold, Silber oder Rhenium.

Weiterhin ist es bevorzugt, wenn die zweite Schicht Aluminium, Titan, Wolfram, deren leitende Silizide, deren leitende Nitride oder deren leitende Oxide enthält.

Insbesondere enthält die zweite Schicht Titan oder ein Titannitrid, insbesondere TiNₓ 0.8 < x < 1.2.

Die Erfindung hat den weiteren Vorteil, daß die Metalle, Metallsilizide, Metallnitride oder Metalloxide der zweiten Schicht im Vergleich zu Photolacken widerstandsfähiger sind, so daß ein chemisches "Veraschen" der Maske verhindert wird. Die hohe Bindungsenergie der Metallatome in Metallen bzw. der Metallionen in Siliziden, Nitriden oder Oxiden führt zu sehr geringen Abtragsraten bei Ätzprozessen mit einem hohen physikalischen Anteil. Dies hat insgesamt zur Folge, daß die Selektivität des Ätzprozesses der ersten Schicht erhöht wird. Durch die geringere Maskenerosion ergibt sich eine höhere Maßhaltigkeit der Strukturierung. Darüber hinaus lassen sich durch das erfindungsgemäße Verfahren auch mit reaktiven Gasen steilere Ätzflanken an der zu strukturierenden Schicht erzielen.

Bevorzugt wird zum Trockenätzen der zweiten Schicht ein Plasmaätzverfahren verwendet.

Weiterhin ist es bevorzugt, wenn während der Trockenätzung der ersten Schicht zumindest ein reaktiver Stoff, insbesondere ein reaktives Gas, vorgesehen ist, der mit dem Material der zweiten Schicht an der Oberfläche der zweiten Schicht zu einer nicht flüchtigen Verbindung reagiert. Auf diese Weise wird der chemische Teil einer chemisch-physikalischen Trockenätzung reduziert und der Abtrag der Ätzung wird im wesentlichen durch den physikalischen Teil der Ätzung bestimmt.

Dabei ist es bevorzugt, daß das reaktive Gas aus einer Gruppe ausgewählt ist, die aus den Gasen Sauerstoff (O₂), Stickstoff (N₂), Wasserstoff (H₂), Halogenen, gasförmige Halogenverbindungen oder einer Mischung dieser Gase besteht.

Weiterhin ist es bevorzugt, wenn während der Trockenätzung der ersten Schicht ein Edelgas, bevorzugt Argon, vorgesehen ist.

Vorteilhafterweise werden zur Trockenätzung der ersten Schicht eine reaktive Ionenätzung (RIE, Reactive Ion Etching), eine magnetfeldunterstützte reaktive Ionenätzung (MERIE, Magnetically Enhanced RIE), eine ECR-Ätzung (ECR, Electron Cyclotron Resonance) oder induktiv gekoppelte Plasmaätzverfahren (ICP, TCP) eingesetzt.

Es ist bevorzugt, wenn die Isolationsschicht eine Siliziumoxidschicht ist oder enthält.

Weiterhin ist es bevorzugt, wenn die Siliziumoxidschicht durch einen TEOS- oder einen Silan-Prozess erzeugt wird.

Als leitende Schicht wird vorteilhafterweise eine Aluminium-, Wolfram- oder Kupferschicht verwendet.

Die Erfindung wird nachfolgend anhand von Figuren der Zeichnung näher dargestellt. Es zeigen:
Figuren 1 bis 3 eine schematische Darstellung eines erfindungsgemäßen Verfahrens zur Erzeugung einer erfindungsgemäßen Elektrodenanordnung,
Figuren 4 bis 6 eine schematische Darstellung eines erfindungsgemäßen Verfahrens zur Kontaktierung der Elektrodenanordnung,
Fig. 7 eine schematische Darstellung einer Ätzkammer in Form eines Parallelplattenreaktors.

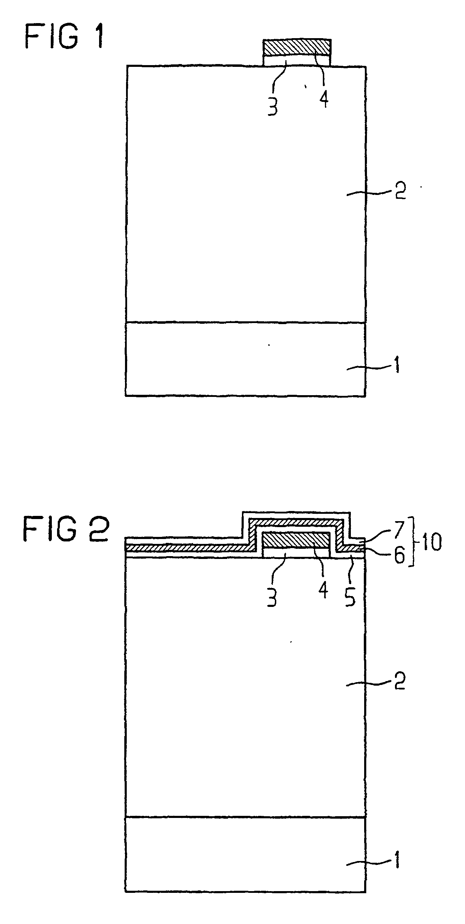

Die Figuren 1 bis 3 zeigen eine schematische Darstellung des erfindungsgemäßen Verfahrens. Auf einem Siliziumsubstrat 1 wird im Rahmen der normalen Prozeßführung mehrfach Oxid abgeschieden, so daß schließlich eine bis zu 2 µm dicke Oxidschicht 2 erzeugt wird. Eine auf die Oxidschicht 2 aufgebrachte Titanschicht 3 dient als Barrierenmaterial für die folgende Platinschicht 4. Die Platinschicht 4 dient im folgenden als Bottomelektrode für den Kondensator einer Speicherzelle und ist deshalb mit einem Kontakt (nicht gezeigt) versehen. Die Platinschicht 4 kann beispielsweise durch Sputtern aufgebracht werden. Nachfolgend werden die Platinschicht 4 und die Titanschicht 3 strukturiert. Diese Strukturierung der Platinschicht 4 kann mittels einer TiN-Hardmask analog zu der im folgenden beschriebenen Strukturierung der Topelektrode erfolgen. Jedoch wird bei der Platinschicht 4 (Bottomelektrode) die TiN-Hardmask nach der Strukturierung wieder entfernt. Die sich daraus ergebende Struktur ist in Fig. 1 gezeigt.

Anschließend wird eine Bariumstrontiumtitanatschicht 5 (BST, (Ba,Sr)TiO₃) auf die in Fig. 1 gezeigte Struktur aufgebracht. Diese Schicht wird später in der vollständigen Speicherzelle als Dielektrikum des Speicherkondensators verwendet. Auf die Bariumstrontiumtitanatschicht 5 wird eine weitere Platinschicht 6 als erste leitende Schicht der erfindungsgemäßen Elektrodenanordnung aufgebracht. Nachfolgend wird eine Titannitrid-Schicht 7 als zweite leitende Schicht der erfindungsgemäßen Elektrodenanordnung 10 auf der Platinschicht 6 erzeugt. Die sich daraus ergebende Struktur ist in Fig. 2 gezeigt.

Die Titannitridschicht 7 wird nun mittels einer Phototechnik strukturiert, um als "Hardmask" zur Strukturierung der Platinschicht 6 und der Bariumstrontiumtitanatschicht 5 dienen zu können.

Nachfolgend wird ein reaktives Ionenätzen (RIE, Reactive Ion Etching) durchgeführt, um die Platinschicht 6 einem chemisch-physikalischen Trockenätzen zu unterziehen. Als Ätzgas wird dabei Sauerstoff O₂ oder ein Gemisch aus O₂ und weiteren Gasen, z.B. Argon, verwendet. Anstatt des reaktiven Ionenätzens können auch andere Trockenätzverfahren wie beispielsweise das Ionenätzen, das magnetfeldunterstützte reaktive Ionenätzen (MERIE, Magnetically Enhanced RIE), das ECR-Ätzen (ECR, Electron Cyclotron Resonance) oder induktiv gekoppelte Plasmaätzverfahren (ICP, TCP) eingesetzt werden.

Während des Trockenätzens der Platinschicht 6 werden auf der Oberfläche der Titannitridmaske 7 laufend nicht flüchtige Titanoxidschichten (TiₓO_{y}) nachgebildet, wodurch die Ätzrate der Titannitridmaske 7 noch weiter gesenkt wird. Entsprechend wird somit die Selektivität des Ätzprozesses deutlich erhöht. Durch die damit verbundene geringere Maskenerosion ergibt sich eine höhere Maßhaltigkeit der Strukturierung. Durch eine geeignete Wahl der O₂-Konzentration läßt sich der Flankenwinkel der Ätzflanke an der Platinschicht 6 über einen großen Bereich einstellen. Auf diese Weise läßt sich die erfindungsgemäße Elektrodenanordnung mit hoher Maßhaltigkeit herstellen.

Sind die durch die Titannitridmaske nicht geschützten Bereiche der Platinschicht 6 entfernt, werden die entsprechenden Bereiche der Bariumstrontiumtitanatschicht 5 dem reaktiven Ionenätzen unterzogen. Wiederum wird als Ätzgas dabei Sauerstoff O₂ oder ein Gemisch aus O₂ und weiteren Gasen, z.B. Argon, verwendet, um die Titannitrid-Hardmask 7 weiter zu "härten".

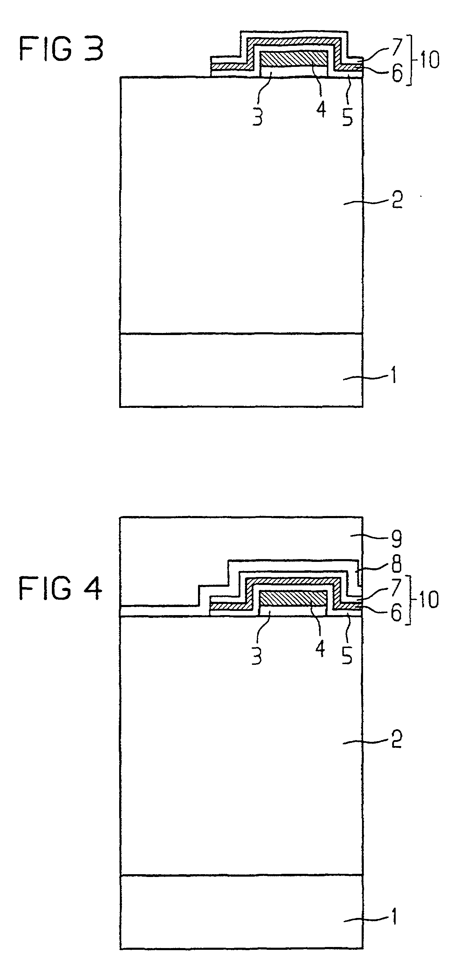

Anstatt des reaktiven Ionenätzens können auch bei der Trockenätzung der Bariumstrontiumtitanatschicht 5 andere Trockenätzverfahren wie beispielsweise das Ionenätzen, das magnetfeldunterstützte reaktive Ionenätzen (MERIE, Magnetically Enhanced RIE), das ECR-Ätzen (ECR, Electron Cyclotron Resonance) oder induktiv gekoppelte Plasmaätzverfahren (ICP, TCP) eingesetzt werden. Die sich nach der Trockenätzung der Bariumstrontiumtitanatschicht 5 ergebende Struktur ist in Fig. 3 gezeigt.

Das erfindungsgemäße Verfahren 10 hat den Vorteil, daß sich durch die Titannitridschicht 7 (zweite Schicht der Elektrodenanordnung), bei etwa gleichbleibender Kapazität, der Schichtwiderstand der gesamten Elektrodenanordnung 10 verringert. Dadurch wird das Schalten der sogenannten "common plate" beim sogenannten "pulsed-plateline" Betrieb der Speicherzelle beschleunigt, wodurch sich die Zugriffszeit des gesamten Bausteins verkürzt.

Auf die in Fig. 3 gezeigte Struktur wird zur Isolation ganzflächig eine dünne SiO₂-Schicht 8, beispielsweise durch einen TEOS-Prozeß, aufgebracht. Da die Abscheidung einer Oxidschicht auf Platin problematisch ist, ermöglicht die Titannitridschicht 7 (zweite Schicht der Elektrodenanordnung) eine Einkapselung des Kondensators der Speicherzelle mit einer Oxidschicht. Anschließend wird auf die dünne SiO₂-Schicht 8 eine Lackschicht 9 aufgebracht. Die sich daraus ergebende Struktur ist in Fig. 4 gezeigt.

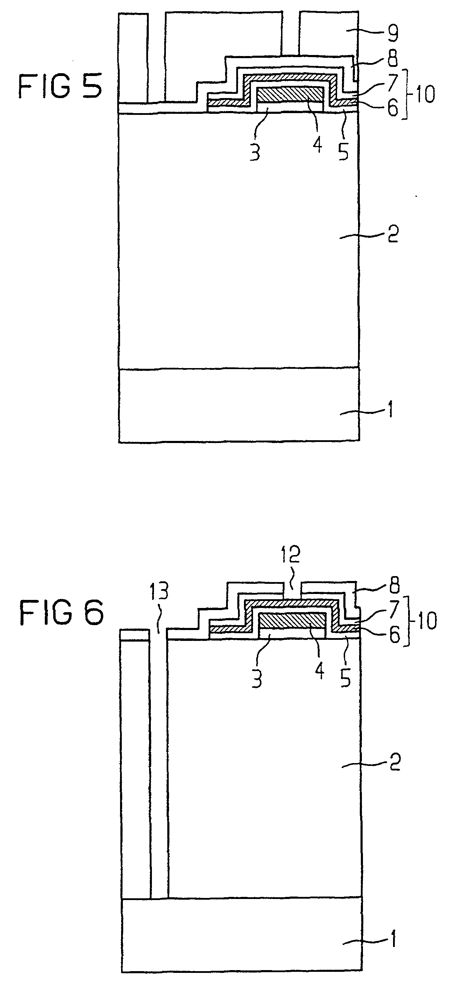

An den Stellen, an denen später Kontaktlöcher entstehen sollen wird die Lackschicht 9 belichtet. Anschließend wird die Lackmaske entwickelt, d.h. die belichteten Bereiche der Lackschicht 9 werden entfernt. Die sich daraus ergebende Struktur ist in Fig. 5 gezeigt.

Nachfolgend wird ein Plasmaätzprozeß durchgeführt, um die Kontaktlöcher 12 und 13 zu erzeugen. Durch die unterschiedliche Tiefe der Kontaktlöcher 12 und 13 ist die Elektrodenanordnung 10 einer langen Überätzung ausgesetzt.

Jedoch besitzt die Elektrodenanordnung 10 durch die Titannitridschicht 7 (zweite Schicht der Elektrodenanordnung) eine größere Dicke, so daß ein Durchbrechen der Elektrodenanordnung 10 während der Kontaktlochätzung vermieden wird.

Ebenso wird die Bildung von nur schwer entfernbaren Redepositionen aus dem Material der ersten Schicht (Platinschicht 6) während der Überätzung verhindert.

Anschließend wird noch die Lackschicht 9 entfernt, wodurch sich die in Fig. 6 gezeigte Struktur ergibt.

## Patentansprüche

1. Verfahren zur Erzeugung einer Elektrodenanordnung (10) mit den Schritten:
eine erste leitende Schicht (6) der Elektrodenanordnung (10) wird bereitgestellt, wobei das Material der ersten Schicht (6) durch eine chemische Trockenätzung praktisch nicht ätzbar ist,
eine zweite leitende Schicht (7) der Elektrodenanordnung (10) wird auf der ersten Schicht (6) bereitgestellt, wobei das Material der zweiten Schicht (7) durch eine chemische Trockenätzung mit geringer Ätzrate ätzbar ist,
die zweite Schicht (7) wird durch eine chemisch-physikalische Trockenätzung strukturiert, wobei die zweite Schicht (7) während der chemisch-physikalischen Trockenätzung auch durch den chemischen Teil der chemisch-physikalischen Trockenätzung abgetragen wird,
die erste Schicht (6) der Elektrodenanordnung (10) wird unter Verwendun der zweiten strukturierten Schicht (7) als Maske chemisch-physikalisch trockengeätzt, wobei die erste Schicht (6) während der chemisch-physikalischen Trockenätzung vorwiegend durch den physikalischen Teil der chemisch-physikalischen Trockenätzung abgetragen wird,
auf der Elektrodenanordnung (10) wird zumindest eine Isolationsschicht (8) aufgebracht und strukturiert, so daß zumindest ein Kontaktioch (12) zu der Elektrodenanordnung (10) und ein weiteres, außerhalb der Elektrodenanordnung angeordneter Kontaktloch (13) gebildet werden, so dass durch eine unterschiedliche Tiefe der Kontaktlöcher (12, 13) die Elektrodenanordnung (10) einer langen Überätzung ausgesetzt ist, und bei der während der Kontaktlochätzung ein Durchbrechen der Elektrodenanordnung (10) aufgrund der größeren Dicke, die die Elektrodenanordnung (10) durch die zweite Schicht (7) besitzt, vermieden wird, und
eine leitende Schicht wird abgeschieden, so daß die Kontaktlöcher (12, 13) ausgefüllt sind.

2. Verfahren nach Anspruch 1, **dadurch gekennzeichnet, daß** die erste Schicht (6) ein 4d oder 5d Übergangsmetall, deren leitende Nitride oder deren leitende Oxide enthält.

3. Verfahren nach Anspruch 1 oder 2, **dadurch gekennzeichnet, daß** die zweite Schicht (7) Aluminium, Titan, Wolfram, deren leitende Silizide, deren leitende Nitride oder deren leitende Oxide enthält.

4. Verfahren nach einem der Ansprüche 1 bis 3, **dadurch gekennzeichnet, daß** die erste Schicht (6) Ruthenium, Rhodium, Palladium, Osmium, Iridium, Platin, Gold, Silber oder Rhenium enthält.

5. Verfahren nach einem der Ansprüche 1 bis 4, **dadurch gekennzeichnet, daß** die zweite Schicht (7) Titan oder ein Titannitrid, insbesondere TiNₓ 0.8 < x < 1.2, enthält

6. Verfahren nach einem der vorhergehenden Ansprüche, **dadurch gekennzeichnet, daß** zum Trockenätzen der zweiten Schicht (7) ein Plasmaätzverfahren verwendet wird.

7. Verfahren nach einem der vorhergehenden Ansprüche, **dadurch gekennzeichnet, daß** während der Trockenätzung der ersten Schicht (6) zumindest ein reaktives Gas vorgesehen ist, das mit dem Material der zweiten Schicht (7) an der Oberfläche der zweiten Schicht (7) zu einer nicht flüchtigen Verbindung reagiert,
und daß das reaktive Gas Sauerstoff (O₂), Stickstoff (N₂), Wasserstoff (H₂), ein Halogen, eine gasförmige Halogenverbindung oder einer Mischung dieser Gase oder ein Edelgas ist.

8. Verfahren nach einem der vorhergehenden Ansprüche, **dadurch gekennzeichnet, daß** zur Trockenätzung der ersten Schicht (6) eine reaktive Ionenätzung (RIE, Reactive Ion Etching), eine magnetfeldunterstützte reaktive Ionenätzung (MERIE, Magnetically Enhanced RIE), eine ECR-Ätzung (ECR, Electron Cyclotron Resonance) oder induktiv gekoppelte Plasmaätzverfahren (ICP, TCP) eingesetzt werden.

9. Verfahren nach einem der vorhergehenden Ansprüche, **dadurch gekennzeichnet, daß** die Isolationsschicht (8) eine Siliziumoxidschicht ist oder eine Siliziumschicht enthält.

10. Verfahren nach Anspruch 9, **dadurch gekennzeichnet, daß** die Siliziumoxidschicht (8) durch einen TEOS- oder einen Silan-Prozeß erzeugt wird.

11. Verfahren nach einem der vorhergehenden Ansprüche, **dadurch gekennzeichnet, daß** als leitende Schicht eine Aluminium-, Wolfram- oder Kupferschicht verwendet wird.

## Claims

1. Method for producing an electrode arrangement (10) having the steps:
a first conductive layer (6) of the electrode arrangement (10) is made available, the material of the first layer (6) being virtually impossible to etch by means of chemical dry etching,
a second conductive layer (7) of the electrode arrangement (10) is made available on the first layer (6), the material of the second layer (7) being etchable by means of chemical dry etching with a low etching rate,
the second layer (7) is structured by means of chemical-physical dry etching, the second layer (7) being also deposited by the chemical part of the chemical-physical dry etching during the chemical-physical dry etching,
the first layer (6) of the electrode arrangement (10) is dry etched by a chemical-physical process using the second structured layer (7) as a mask, the first layer (6) being predominantly deposited by the physical part of the chemical-physical dry etching during the chemical-dry etching,
at least one insulating layer (8) is applied to the electrode arrangement (10) and patterned in such a way that at least one contact hole (12) to the electrode arrangement (10) and one further contact hole (13), arranged outside the electrode arrangement, are formed, with the result that due to a different depth of the contact holes (12, 13) the electrode arrangement (10) is subjected to long over-etching, in which the electrode arrangement (10) is prevented from breaking through during the etching of the contact holes owing to the greater thickness which the electrode arrangement (10) has as a result of the second layer (7), and
a conductive layer is deposited so that the contact holes (12, 13) are filled in.

2. Method according to Claim 1, **characterized in that** the first layer (6) contains a 4d or 5d transition metal, its conductive nitrides or its conductive oxides.

3. Method according to Claim 1 or 2, **characterized in that** the second layer (7) contains aluminium, titanium, tungsten, their conductive silicides, their conductive nitrides or their conductive oxides.

4. Method according to one of Claims 1 to 3, **characterized in that** the first layer (6) contains ruthenium, rhodium, palladium, osmium, iridium, platinum, gold, silver or rhenium.

5. Method according to one of Claims 1 to 4, **characterized in that** the second layer (7) contains titanium or a titanium nitride, in particular TiNₓ 0.8 < x < 1.2.

6. Method according to one of the preceding claims, **characterized in that** a plasma etching method is used for dry-etching the second layer (7).

7. Method according to one of the preceeding claims, **characterized in that**, during the dry-etching of the first layer (6), at least one reactive substance is provided which reacts with the material of the second layer (7) on the surface of the second layer (7) to form a non-volatile compound, and **in that** the reactive gas is oxygen (O₂), nitrogen (N₂), hydrogen (H₂), a halogen, a gaseous halogen compound or a mixture of these gases or an inert gas.

8. Method according to one of the preceding claims, **characterized in that** reactive ion etching (RIE), magnetically enhanced reactive ion etching (MERIE), ECR (Electron Cyclotron Resonance) etching or inductively coupled plasma etching methods (ICP, TCP) are used for dry-etching the first layer (6).

9. Method according to one of the preceding claims, **characterized in that** the insulation layer (8) is a silicon oxide layer, or contains a silicon layer.

10. Method according to Claim 9, **characterized in that** the silicon oxide layer (8) is produced by means of a TEOS process or a silane process.

11. Method according to one of the preceding claims, **characterized in that** an aluminium, tungsten or copper layer is used as conductive layer.

## Revendications

1. Procédé de production d'une structure (10) d'électrode comprenant les stades :
on dispose une première couche (6) conductrice de la structure (10) d'électrode , la matière de la première couche (6) ne pouvant pratiquement pas être attaquée par une attaque chimique par voie sèche,
on dispose une deuxième couche (7) conductrice de la structure (10) d'électrode sur la première couche (6), la matière de la deuxième couche (7) pouvant être attaquée par une attaque chimique par voie sèche à une petite vitesse d'attaque,
on structure la deuxième couche (7) par une attaque chemio-physique par voie sèche, la deuxième couche (7) étant, pendant l'attaque chemio-physique par voie sèche, enlevée aussi par la partie chimique de l'attaque chemio-physique par voie sèche,
on attaque chemio-physiquement par voie sèche la première couche (6) de la structure (10) d'électrode en utilisant la deuxième couche (7) structurée comme masque, la première couche (6) étant enlevée pendant l'attaque chemio-physique par voie sèche principalement par la partie physique de l'attaque chemio-physique par voie sèche,
on dépose et on structure sur la structure (10) d'électrode au moins une couche (9) d'isolement, de manière à former au moins un trou (12) métallisé par rapport à la structure (10) d'électrode et un autre trou (13) métallisé disposé à l'extérieur de la structure d'électrode, de sorte que, par une différence de profondeur des trous (12, 13) métallisés, la structure (10) d'électrode soit soumise à une attaque excessive longue dans laquelle, pendant l'attaque des trous métallisés, il est évité que la structure (10) d'électrode ne soit percée en raison de l'épaisseur plus grande que la structure (10) d'électrode possède par la deuxième couche (7) et
on dépose une couche conductrice de manière à combler les trous (12, 13) métallisés.

2. Procédé suivant la revendication 1, **caractérisé en ce que** la première couche (6) contient un métal de transition 4d ou 5d, leurs nitrures conducteurs ou leurs oxydes conducteurs.

3. Procédé suivant la revendication 1 ou 2, **caractérisé en ce que** la deuxième couche (7) contient de l'aluminium, du titane, du tungstène, leurs siliciures conducteurs, leurs nitrures conducteurs ou leurs oxydes conducteurs.

4. Procédé suivant l'une des revendications 1 à 3, **caractérisé en ce que** la première couche (6) contient du ruthénium, du rhodium, du palladium, de l'osmium, de l'iridium, du platine, de l'or, de l'argent ou du rhénium.

5. Procédé suivant l'une des revendications 1 à 4, **caractérisé en ce que** la deuxième couche (7) contient du titane ou un nitrure de titane, notamment TiNₓ 0,8 < x < 1,2.

6. Procédé suivant l'une des revendications précédentes, **caractérisé en ce que** l'on utilise pour l'attaque par voie sèche de la deuxième couche (7) un procédé d'attaque au plasma.

7. Procédé suivant l'une des revendications précédentes, **caractérisé en ce qu'**il est prévu pendant l'attaque par voie sèche de la première couche (6) au moins un gaz réactif qui réagit sur la matière de la deuxième couche (7) à la surface de la deuxième couche (7) pour donner un composé non volatil,
et **en ce que** le gaz réactif est de l'oxygène (O₂), de l'azote (N₂), de l'hydrogène (H₂), un halogène, un composé halogéné gazeux ou un mélange de ces gaz ou un gaz rare.

8. Procédé suivant l'une des revendications précédentes, **caractérisé en ce que** pour l'attaque par voie sèche de la première couche (6) on met en oeuvre une attaque réactive ionique (RIE, Reactive Ion Etching), une attaque réactive ionique exaltée par champ magnétique (MERIE, Magnetically Enhanced RIE), ou une attaque ECR (ECR, Electron Cyclotron Resonance) ou un procédé d'attaque au plasma à couplage inductif (ICP, TCP).

9. Procédé suivant l'une des revendications précédentes, **caractérisé en ce que** la couche (8) d'isolement est une couche d'oxyde de silicium ou contient une couche d'oxyde de silicium.

10. Procédé suivant la revendication 9, **caractérisé en ce que** la couche (8) d'oxyde de silicium est produite par une opération au TEOS ou au silane.

11. Procédé suivant l'une des revendications précédentes, **caractérisé en ce que** l'on utilise comme couche conductrice une couche d'aluminium, une couche de tungstène ou une couche cuivre.
